# EUROPÄISCHE PATENTSCHRIFT

(11) **EP 1 800 353 B1**
(45) Veröffentlichungstag und Bekanntmachung des Hinweises auf die Patenterteilung: **14.10.2015**
(21) Anmeldenummer: 05774738.8
(22) Anmeldetag: 04.08.2005
(51) Int. Cl.: H01L 33/50

(54) **Verfahren zum Herstellen von Lumineszenzdiodenchips**
Methods for the production of luminescent diode chips
Procédé de production de puces à diode électroluminescente

(30) Priorität: 30.09.2004 DE 102004047644; 15.12.2004 DE 102004060358
(43) Veröffentlichungstag der Anmeldung: 27.06.2007
(73) Patentinhaber: OSRAM Opto Semiconductors GmbH, 93055 Regensburg (DE)
(72) Erfinder: BRUNNER, Herbert, 93161 Sinzing (DE); EISSLER, Dieter, 93152 Nittendorf (DE); HAHN, Berthold, 93155 Hemau (DE); HÄRLE, Volker, 93164 Laaber (DE); JÄGER, Harald, 93049 Regensburg (DE); KRÄUTER, Gertrud, 93051 Regensburg (DE); WAITL, Günter, 93049 Regensburg (DE)
(74) Vertreter: Epping - Hermann - Fischer
(86) Internationale Anmeldenummer: PCT/DE2005/001382
(87) Internationale Veröffentlichungsnummer: WO 2006/034663

(56) Entgegenhaltungen:
- WO-A-01/65613
- WO-A-97/48138
- US-A1- 2003 080 341
- US-A1- 2004 056 260
- US-A1- 2004 120 155
- US-A1- 2004 166 234
- US-B1- 6 744 196

## Beschreibung

Die Erfindung betrifft einen Lumineszenzdiodenchip, der mit einem Lumineszenzkonversionsmaterial versehen ist, das mindestens einen Leuchtstoff aufweist. Weiterhin betrifft die Erfindung ein Verfahren zum Herstellen derartiger Lumineszenzdiodenchips.

Bei optoelektronischen Bauelementen, die elektromagnetische Strahlung emittieren, ist es bekannt, Lumineszenzdiodenchips mittels einer Vergussmasse einzukapseln, in die ein Lumineszenzkonversionsmaterial mit mindestens einem Leuchtstoff gemischt ist. Das Einkapseln erfolgt z.B. durch Vergießen einer Gehäusekavität, in der ein Lumineszenzdiodenchip montiert ist, oder durch Umspritzen eines auf einem Leiterrahmen montierten Lumineszenzdiodenchips mittels Spritzpressen.

Der Leuchtstoff ist durch eine von dem Lumineszenzdiodenchip emittierte elektromagnetische Primärstrahlung anregbar und emittiert eine Sekundärstrahlung, wobei die Primärstrahlung und die Sekundärstrahlung unterschiedliche Wellenlängenbereiche aufweisen. Ein gewünschter resultierender Farbort des Bauelements kann beispielsweise durch ein Einstellen eines Mischungsverhältnisses der Primärstrahlung und der Sekundärstrahlung eingestellt werden.

Bei einer Verwendung derartiger Vergussmassen kann es zu Farbortschwankungen aufgrund einer inhomogenen Verteilung des Leuchtstoffes in der Vergussmasse kommen, die z.B. auf einer Sedimentationsbildung von Leuchtstoffpartikeln beruhen kann. Zudem gibt es Fertigungstoleranzen bezüglich einer Dosierbarkeit der Vergussmasse, der Höhen von Lumineszenzdiodenchips und/oder einer Positionierbarkeit der Lumineszenzdiodenchips in der Kavität eines Spritzwerkzeugs. Dies kann zu signifikanten Schwankungen der Menge der Vergussmasse, die dem Lumineszenzdiodenchip in einer Abstrahlrichtung nachgeordnet ist, und somit auch zu Schwankungen des Farbortes des Bauelements führen. Weiterhin wirken sich hohe Anschaffungskosten für Zubehör zum präzisen Dosieren der Vergussmasse und ein Verschleiß dieses Zubehörs aufgrund der Abrasivität des Lumineszenzkonversionsmaterials bzw. des Leuchtstoffs in nicht zu vernachlässigender Weise auf die Herstellungskosten des Bauelements aus.

In der WO 01/65613 A1 ist ein Verfahren zur Herstellung von Halbleiterbauelementen offenbart, bei dem ein Lumineszenzkonversionselement direkt auf den Halbleiterkörper aufgebracht wird. Dies hat den Vorteil, dass Leuchtstoffe homogen und in einer wohldefinierten Menge auf dem Halbleiterkörper aufgebracht werden können. Dadurch lässt sich ein homogener Farbeindruck des lichtabstrahlenden Halbleiterchips erreichen.

Bei dem Verfahren wird der Halbleiterkörper auf einem Träger montiert, mit Kontakten versehen und mit einem Lumineszenzkonversionselement beschichtet. Das Beschichten erfolgt entweder mittels einer geeigneten Suspension, die ein Lösungsmittel aufweist, das nach dem Auftragen entweicht, oder durch Beschichten mit einem Haftvermittler, auf dem nachfolgend der Leuchtstoff aufgebracht wird.

Die Druckschrift WO 97/48138A beschreibt ein Verfahren gemäß dem Oberbegriff des Patentanspruchs 1.

Es ist eine Aufgabe der vorliegenden Erfindung, ein verbessertes Verfahren zum Herstellen von mit einem Lumineszenzkonversionsmaterial versehenen Lumineszenzdiodenchips bereitzustellen, das insbesondere auf eine einfache und kostengünstige Weise durchführbar ist.

Diese Aufgabe wird durch ein Verfahren gemäß Anspruch 1 gelöst. Vorteilhafte Ausführungsformen und bevorzugte Weiterbildungen der Verfahren sind Gegenstand der abhängigen Patentansprüche.

Bei den Verfahren wird ein Schichtenverbund bereitgestellt, der eine Lumineszenzdioden-Schichtfolge für eine Vielzahl von Lumineszenzdiodenchips umfasst und der auf einer Hauptfläche für jeden Lumineszenzdiodenchip mindestens eine elektrische Kontaktfläche zum elektrischen Anschließen der Lumineszenzdiodenchips aufweist.

Gemäß einem ersten, nicht erfindungsgemäßem Verfahren wird auf die Hauptfläche des Schichtenverbundes eine Schicht Haftvermittler aufgebracht, die nachfolgend selektiv von zumindest Teilen der Kontaktflächen entfernt wird. Ein weiterer Verfahrensschritt umfasst das Aufbringen von mindestens einem Leuchtstoff auf die Hauptfläche des Schichtenverbundes.

Bei einem zweiten, erfindungsgemäßen Verfahren wird das Lumineszenzkonversionsmaterial auf die Hauptfläche des Schichtenverbundes aufgebracht. Weiterhin wird das Lumineszenzkonversionsmaterial von zumindest Teilen der Kontaktflächen selektiv entfernt.

Bei den Verfahren wird das Lumineszenzkonversionsmaterial auf technisch einfache Weise im wesentlichen gleichzeitig auf eine Vielzahl von Lumineszenzdiodenchips eines gemeinsamen Schichtenverbundes, beispielsweise eines kompletten Wafers aufgebracht. Da der Haftvermittler bzw. das Lumineszenzkonversionsmaterial selektiv von zumindest Teilen der Kontaktflächen entfernt wird, können die nach den Verfahren hergestellten Lumineszenzdiodenchips wie herkömmliche Lumineszenzdiodenchips verwendet und insbesondere auch elektrisch kontaktiert werden.

Das Freilegen der Kontaktflächen erfolgt im wesentlichen in Bereichen, die lateral mit den Kontaktflächen überlappen, so dass das Lumineszenzkonversionsmaterial bzw. der Leuchtstoff, die in einer wohldefinierten, bevorzugt dünnen Schicht aufgebracht werden, durch das Freilegen der Kontaktflächen im wesentlichen nicht beeinflusst werden. Die Kontaktflächen werden durch das selektive Entfernen des Haftvermittlers bzw. des Lumineszenzkonversionsmaterials zumindest teilweise freigelegt, wobei der Haftvermittler bzw. das Lumineszenzkonversionsmaterial im wesentlichen nur im Bereich der Kontaktflächen entfernt wird.

Das selektive Entfernen des Haftvermittlers gemäß dem ersten, nicht erfindungsgemäßen Verfahren ist insbesondere dann von Vorteil, wenn sich der Haftvermittler leichter entfernen lässt als ein Lumineszenzkonversionsmaterial. Zudem sind dadurch vorteilhafterweise die Kontaktflächen noch vor Aufbringen des Leuchtstoffes freigelegt, so dass dieser durch den Verfahrensschritt des Freilegens nicht negativ beeinflusst werden kann.

Bei einem Aufbringen des Lumineszenzkonversionsmaterials gemäß dem zweiten, erfindungsgemäßen Verfahren wird mit Vorteil zunächst ein Haftvermittler und nachfolgend mindestens ein Leuchtstoff aufgebracht. Alternativ wird bevorzugt ein haftendes Lumineszenzkonversionsmaterial in einem einzigen Verfahrensschritt aufgebracht, so dass ein Verfahrensschritt eingespart werden kann.

Der Schichtenverbund weist bevorzugt eine auf einem Träger aufgebrachte epitaktisch gewachsene Halbleiterschichtenfolge auf. Die Halbleiterschichtenfolge ist mit Vorteil entweder direkt auf dem Träger epitaktisch aufgewachsen oder, nachdem sie epitaktisch gewachsen worden ist, auf dem Träger aufgebracht.

Die Lumineszenzdioden-Schichtenfolge des Schichtenverbundes muss nicht notwendigerweise einstückig ausgebildet sein, sondern ist bei einer vorteilhaften Ausführungsform der Verfahren zu einer Vielzahl von Lumineszenzdiodenchips vereinzelt, die auf einem gemeinsamen Träger aufgebracht und durch diesen in einem Schichtenverbund gehalten sind. Dadurch kann das Lumineszenzkonversionsmaterial auf Seitenflächen der Lumineszenzdiodenchips aufgebracht werden. Alternativ wird dies zumindest teilweise mit Vorteil dadurch erreicht, dass eine einstückig ausgebildete Lumineszenzdioden-Schichtenfolge entlang von Trennungslinien zum Trennen der Vielzahl von Lumineszenzdiodenchips von der Hauptfläche her mit Gräben versehen wird.

Der Leuchtstoff bzw. das Lumineszenzkonversionsmaterial wird in einem nicht erfindungsgemäßen Verfahren mittels Rakeln aufgebracht. Dadurch kann das jeweilige Material technisch einfach und kostengünstig in einer dünnen, gleichmäßigen Schicht großflächig über der gesamten Hauptfläche des Schichtenverbundes aufgebracht werden.

Alternativ wird der Leuchtstoff bzw. das Lumineszenzkonversionsmaterial in einem weiteren, nicht erfindungsgemäßen Verfahren mittels Eintauchen in ein Konvertermaterial aufgebracht, das den Leuchtstoff bzw. das Lumineszenzkonversionsmaterial oder eine Vorstufe hiervon enthält. Hierbei handelt es sich vorteilhafterweise um einen besonders kostengünstigen Prozess, mittels dem ebenfalls dünne, gleichmäßige Materialschichten großflächig aufgebracht werden können.

Erfindungsgemäß wird der Leuchtstoff bzw. das Lumineszenzkonversionsmaterial mittels eines elektrostatischen Pulversprühprozesses aufgebracht. Dieser eignet sich für ein besonders fein dosierbares und gleichmäßiges Aufbringen eines Leuchtstoffes bzw. eines in fester Form vorliegenden Lumineszenzkonversionsmaterials. Das Lumineszenzkonversionsmaterial wird erfindungsgemäß mittels eines Pulverlackierprozesses aufgebracht, bei dem es zunächst mittels eines elektrostatischen Pulversprühprozesses aufgebracht sowie, zum Erzielen einer Haftung an der Hauptfläche, erhitzt wird. Der Pulverlackierprozess eignet sich für ein besonders fein dosierbares und gleichmäßiges Aufbringen des Lumineszenzkonversionsmaterials.

Bei einem weiteren, nicht erfindungsgemäßen Prozess wird der Leuchtstoff bzw. das Lumineszenzkonversionsmaterial mit Vorteil mittels Vernebelns eines Konvertermaterials aufgebracht, das den Leuchtstoff bzw. das Lumineszenzkonversionsmaterial oder eine Vorstufe hiervon enthält. Dies ist ein technisch einfacher und kostengünstiger Prozess, mittels dem das jeweilige Material gleichmäßig aufgebracht werden kann.

Besonders bevorzugt erfolgt das Vernebeln unter Verwendung von flüchtigen Treibmitteln und zusätzlich oder alternativ unter Verwendung eines Luftstromes.

Das Aufbringen des Leuchtstoffs bzw. des Lumineszenzkonversionsmaterials mittels Vernebelns kann mehrfach erfolgen.

Dadurch kann vorteilhafterweise eine besonders gute Dosierbarkeit des Auftragsprozesses erreicht werden. Auf diese Weise können auch mehrere Schichten mit verschiedenen Leuchtstoffen bzw. mehrere Schichten verschiedener Lumineszenzkonversionsmaterialien aufgebracht werden.

Nach dem Aufbringen wird der Haftvermittler bzw. das Lumineszenzkonversionsmaterial bevorzugt mittels eines lithografischen Prozesses selektiv entfernt. Mit Vorteil wird hierfür ein photolithografischer Prozess verwendet, bei dem eine Maske durch Aufbringen einer Maskenmaterialschicht und Strukturieren von dieser erzeugt wird. Dies ist vorteilhafterweise ein Standardprozess, mittels dem in der Optoelektronik üblicherweise Halbleiterschichten oder Kontaktmetallflächen strukturiert werden.

Alternativ umfasst der lithografische Prozess die Verwendung einer vorgefertigten Maske, die auf der Hauptfläche aufgebracht wird. Dadurch kann auf ein Herstellen einer Maske durch Aufbringen und Strukturieren einer Schicht aus Maskenmaterial verzichtet werden.

Als eine Alternative zu dem lithografischen Prozess wird der Haftvermittler bzw. das Lumineszenzkonversionsmaterial unter Verwendung von Laserstrahlung entfernt, d.h. das jeweilige Material wird durch eine Einwirkung der Laserstrahlung selektiv abgetragen.

Der erfindungsgemäße Lumineszenzdiodenchip weist auf einer Hauptfläche mindestens eine elektrische Kontaktfläche auf, wobei die Hauptfläche mit einem Lumineszenzkonversionsmaterial versehen ist. In einem Bereich, der lateral mit der Kontaktfläche überlappt, weist das Lumineszenzkonversionsmaterial eine derartige Ausnehmung auf, dass die elektrische Kontaktfläche freigelegt ist, d.h. dass zumindest ein Teil der elektrischen Kontaktfläche frei von dem Lumineszenzkonversionsmaterial ist.

Weitere Vorteile, bevorzugte Ausführungsformen und Weiterbildungen der Verfahren ergeben sich aus den im Folgenden in Verbindung mit den Figuren 1a bis 6d erläuterten Ausführungsbeispielen. Es zeigen:
- Figuren 1a bis 1d: schematische Schnittansichten eines Schichtenverbunds bei verschiedenen Verfahrensstadien eines ersten Ausführungsbeispiels eines nicht-erfindungsgemäßen Verfahrens,
- Figuren 2a bis 2c: schematische Schnittansichten eines Schichtenverbundes bei verschiedenen Verfahrensstadien eines zweiten Ausführungsbeispiels eines erfindungsgemäßen Verfahrens,
- Figuren 3a bis 3d: schematische Schnittansichten eines Schichtenverbundes bei verschiedenen Verfahrensstadien eines dritten Ausführungsbeispiels eines erfindungsgemäßen Verfahrens,
- Figuren 4a und 4b: schematische Schnittansichten verschiedener Ausführungsbeispiele eines Schichtenverbundes,
- Figuren 5a bis 5d: schematische Schnittansichten eines Teilbereichs eines Schichtenverbundes bei verschiedenen Verfahrensstadien eines vierten Ausführungsbeispiels eines erfindungsgemäßen Verfahrens, und
- Figuren 6a bis 6d: schematische Schnittansichten eines Teilbereichs eines Schichtenverbundes bei verschiedenen Verfahrensstadien eines fünften Ausführungsbeispiels eines erfindungsgemäßen Verfahrens.

In den Ausführungsbeispielen und Figuren sind gleiche oder gleichwirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

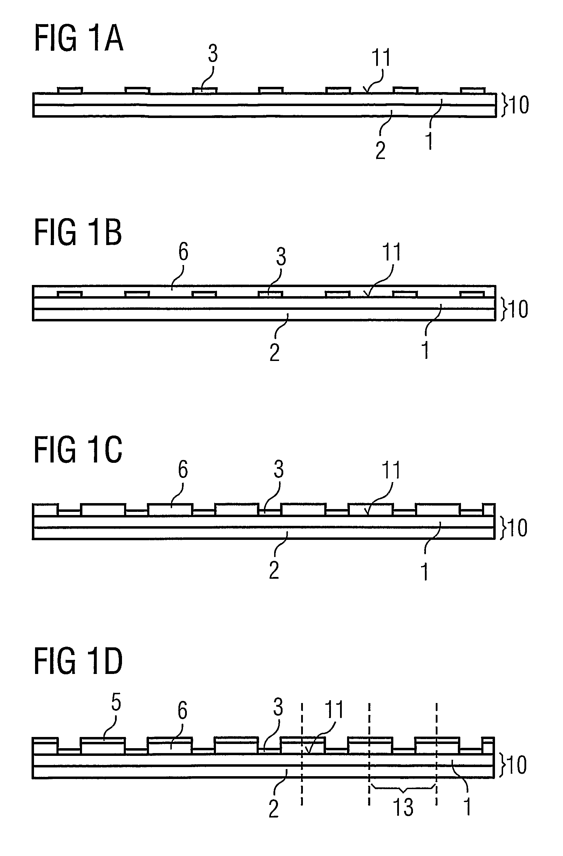

In Figur 1a ist ein Schichtenverbunden 10 dargestellt, der eine Lumineszenzdioden-Schichtenfolge 1 aufweist, die auf einem Träger 2 aufgebracht ist. Die Lumineszenzdioden-Schichtenfolge 1 ist beispielsweise eine epitaktisch gewachsene Halbleiterschichtenfolge, die für eine Vielzahl von Lumineszenzdiodenchips vorgesehen ist. Der Träger 2 ist z.B. ein Aufwachssubstrat, auf dem die Lumineszenzdioden-Schichtenfolge aufgewachsen ist.

Alternativ ist der Schichtenverbund 10 ein Dünnfilm-Schichtenverbund, bei dem die Lumineszenzdioden-Schichtenfolge 1 auf einem separaten Aufwachssubstrat aufgewachsen, nachfolgend von diesem abgelöst sowie auf dem Träger 2, der beispielsweise ein Trägersubstrat aus einem Halbleitermaterial ist, aufgebracht, beispielsweise aufgelötet worden ist. Zwischen der Lumineszenzdioden-Schichtenfolge 1 und dem Träger 2 ist z.B. eine reflektierende elektrische Kontaktstruktur angeordnet (nicht gezeigt), an der eine in der Lumineszenzdioden-Schichtenfolge 1 erzeugte elektromagnetische Strahlung reflektiert wird und mittels der die Lumineszenzdioden-Schichtenfolge z.B. elektrisch leitend mit dem Träger 2 verbunden ist.

Die Lumineszenzdioden-Schichtenfolge 1 ist beispielsweise auf Nitrid-Verbindungshalbleitern basierend, d.h. sie enthält vorzugsweise AlₓIn_{y}Ga_{1-x-y}N, wobei 0 ≤ x ≤ 1, 0 ≤ y ≤ 1 und x + y ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im wesentlichen nicht ändern. Der Einfachheit halber beinhaltet obige Formel nur die wesentlichen Bestandteile des Kristallgitters (Al, In, Ga, N), auch wenn diese teilweise durch geringe Mengen weiterer Stoffe ersetzt sein können.

Die Lumineszenzdioden-Schichtenfolge emittiert bei Beaufschlagung mit einem Strom beispielsweise einem elektromagnetische Strahlung aus einem blauen oder ultravioletten Wellenlängenbereich. Sie kann z.B. einen herkömmlichen pn-Übergang, eine Doppelheterostruktur, eine Einfach-Quantentopfstruktur (SQW-Struktur) oder eine Mehrfach-Quantentopfstruktur (MQW-Struktur) aufweisen. Solche Strukturen sind dem Fachmann bekannt und werden von daher an dieser Stelle nicht näher erläutert.

Auf die Hauptfläche 11 des Schichtenverbundes 10 wird ein Haftvermittler 6 aufgebracht (siehe Figur 1b). Der Haftvermittler 6 ist für eine von der Lumineszenzdioden-Schichtenfolge 1 erzeugbare elektromagnetische Strahlung durchlässig und bevorzugt gegenüber dieser alterungsstabil. Beispielsweise wird ein Haftvermittler verwendet, der auf Silikon basiert und der gegenüber UV-Strahlung alterungsstabil ist. Geeignet hierfür ist z.B. klebriges Silikon, wie beispielsweise der von der Firma Wacker angebotene Haftvermittler mit der Produktbezeichnung SLM 647. Den Haftvermittler kann man z.B. entweder etwa 24 Stunden lang bei Raumtemperatur oder etwa eine Stunde lang bei ca. 100°C aushärten lassen.

Nachfolgend wird der Haftvermittler 6 selektiv von den elektrischen Kontaktflächen 3 entfernt, so dass diese zumindest teilweise frei liegen und jeweils elektrisch kontaktierbar sind (siehe Figur 1c).

Bei einem weiteren Verfahrensschritt wird mindestens ein Leuchtstoff 5 auf die Hauptfläche 11 des Schichtenverbundes 10 aufgebracht. Der Leuchtstoff 5 selbst ist nicht haftend, so dass er im wesentlichen nur an den Stellen haften bleibt, an denen Haftvermittler 6 vorhanden ist. Die Kontaktflächen 3 können gegebenenfalls z.B. mittels eines Gasstrahles von Leuchtstoff 5, der nicht an dem Haftvermittler 6 haftet, gesäubert werden.

Der so mit einem Lumineszenzkonversionsmaterial, das z.B. aus dem Haftvermittler 6 und dem Leuchtstoff 5 besteht, versehene Schichtenverbund 10 kann nachfolgend entlang von Trennungslinien, die in Figur 1d mittels gestrichelter Linien angedeutet sind, zu separaten Lumineszenzdiodenchips 13 vereinzelt werden, was beispielsweise mittels Sägen und/oder Ritzen und Brechen erfolgt.

Als Leuchtstoff sind beispielsweise anorganische Leuchtstoffe geeignet, wie mit seltenen Erden, insbesondere mit Ce oder Tb, dotierte Granate, die bevorzugt eine Grundstruktur A₃B₅O₁₂ aufweisen, oder organische Leuchtstoffe, wie Perylen-Leuchtstoffe. Weitere geeignete Leuchtstoffe sind beispielsweise in der WO 98/12757 und in der WO 01/65613 A1 aufgeführt, deren Inhalt insofern hiermit durch Rückbezug aufgenommen wird.

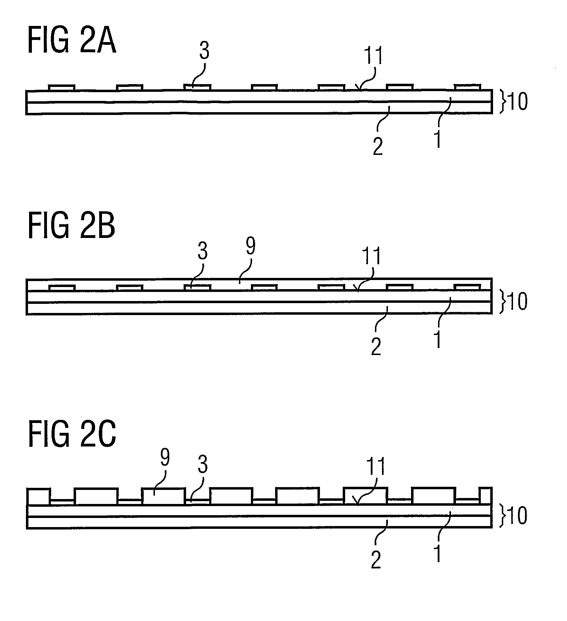

In Figur 2a ist ein Schichtenverbund 10 dargestellt, der beispielsweise wie der vorhergehend anhand Figur 1a erläuterte Schichtenverbund 10 ausgebildet sein kann. Auf diesem wird unmittelbar ein haftendes Lumineszenzkonversionsmaterial 9 aufgebracht, das mindestens einen Leuchtstoff enthält, siehe Figur 2b. Der Gewichtsanteil des Leuchtstoffs beträgt bei dem Lumineszenzkonversionsmaterial 9 mindestens 50 %, bevorzugt mehr als oder gleich 60 Gew-%. Zum Vergleich sei angemerkt, dass Vergussmassen, in die Leuchtstoffe eingemischt sind, typischerweise zwischen 5 und 20 Gew-% Leuchtstoffe aufweisen.

Für das Aufbringen auf Oberflächen des Schichtenverbundes eignen sich grundsätzlich alle für die Anwendung bei LEDs bekannten Konverter. Beispiele für derartige als Konverter geeignete Leuchtstoffe und Leuchtstoffmischungen sind:
- Chlorosilikate, wie beispielsweise in DE 10036940 und dem dort beschriebenen Stand der Technik offenbart,
- Orthosilikate, Sulfide, Thiometalle und Vanadate wie beispielsweise in WO 2000/33390 und dem dort beschriebenen Stand der Technik offenbart,
- Aluminate, Oxide, Halophosphate, wie beispielsweise in US 6616862 und dem dort beschriebenen Stand der Technik offenbart,
- Nitride, Sione und Sialone wie beispielsweise in DE 10147040 und dem dort beschriebenen Stand der Technik offenbart, und
- Granate der Seltenen Erden wie YAG:Ce und der Erdalkalielemente wie beispielsweise in US 2004-062699 und dem dort beschriebenen Stand der Technik offenbart. Der Inhalt der obengenannten Druckschriften wird hinsichtlich der Zusammensetzung und Beschaffenheit der darin beschriebenen Leuchtstoffe sowie Verfahren zu deren Herstellung hiermit ausdrücklich durch Rückbezug aufgenommen.

Bezüglich einer zu erzielenden Emissionsfarbe gibt es bei den Lumineszenzdiodenchips bzw. bei dem Lumineszenzkonversionsmaterial grundsätzlich keine Einschränkungen.

Das Lumineszenzkonversionsmaterial 9 liegt z.B. als eine Masse von geeigneter Viskosität vor, die den Leuchtstoff, einen Haftvermittler (z.B. auf Basis von Silikon) sowie gegebenenfalls weitere Stoffe wie z.B. Lösemittel aufweist. Es wird beispielsweise mittels Rakeln aufgebracht, wobei das Lumineszenzkonversionsmaterial 9 mittels einer Gummilippe oder einer Metallschiene durch die Löcher eines Siebes bzw. einer Schablone gestrichen wird (nicht gezeigt). Die Schablone weist beispielsweise eine Dicke von 125 µm auf und ist mit Löchern versehen, die z.B. einen viereckigen Querschnitt mit einer Seitenlänge von etwa 350 µm aufweisen. Alternativ ist die Schablone etwa 300 µm dick und weist z.B. viereckige Löcher mit einer Kantenlänge von etwa 300 µm auf.

Als Alternative zum Rakeln kann der Schichtenverbund 10 mit der Hauptfläche 11 auch in ein geeignetes Konvertermaterial getaucht werden. Das Rakeln und das Eintauchen eignet sich nicht nur zum Aufbringen von Lumineszenzkonversionsmaterial oder Konvertermaterial, sondern kann z.B. auch zum Aufbringen des Haftvermittlers verwendet werden (siehe das anhand der Figuren 1a bis 1d erläuterte Ausführungsbeispiel).

Weitere mögliche Prozesse zum Aufbringen von Lumineszenzkonversionsmaterial, Konvertermaterial, Leuchtstoffen oder Haftvermittler sind z.B. ein elektrostatischer Pulversprühprozess, ein Pulverlackierprozess oder Vernebeln, worauf nachfolgend noch im Einzelnen eingegangen wird. Aufsprühen oder Auftropfen ist grundsätzlich ebenfalls möglich.

In Figur 2c ist der Schichtenverbund 10 nach einem Verfahrensschritt dargestellt, bei dem das Lumineszenzkonversionsmaterial 9 selektiv von den Kontaktflächen 3 entfernt wird.

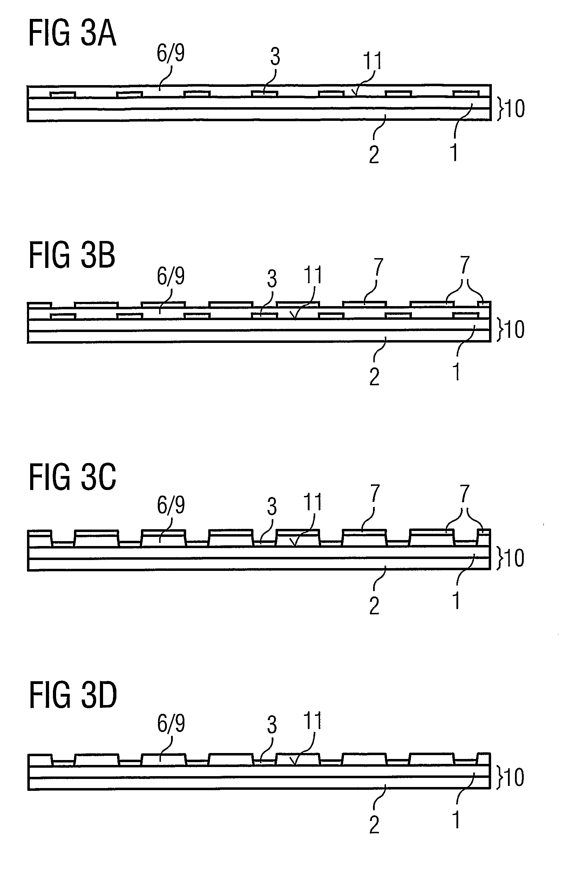

Das selektive Entfernen von Lumineszenzkonversionsmaterial oder von Haftvermittler erfolgt z.B. mittels eines lithografischen Prozesses, wie nachfolgend anhand der Figuren 3a bis 3d erläutert wird. In Figur 3a ist ein mit einer durchgehenden Lumineszenzkonversionsmaterialschicht 9 oder Haftungsmaterialschicht 6 versehener Schichtenverbund 10 dargestellt. Zum selektiven Entfernen des Lumineszenzkonversionsmaterials 9 bzw. des Haftvermittlers 6 wird eine Maske 7 verwendet, siehe Figur 3b, durch die hindurch das entsprechende Material selektiv entfernt wird, was beispielsweise mittels Ätzen mit einem geeigneten Ätzmittel erfolgt, siehe Figur 3c.

Wenn das Lumineszenzkonversionsmaterial Silikon aufweist, lässt es sich beispielsweise mittels trockener Chlorchemie, Essigsäure und/oder Flusssäure ätzen.

Die Maske 7 kann z.B. in einem photolithografischen Prozess durch Aufbringen sowie Strukturieren einer Schicht Maskenmaterial erfolgen. Alternativ ist es möglich, eine vorgefertigte Maske 7 zu verwenden, die auf der Hauptfläche 11 des Schichtenverbundes 10 aufgebracht wird. In beiden Fällen wird die Maske bzw. das Maskenmaterial nach dem selektiven Entfernen des Lumineszenzkonversionsmaterials 9 bzw. des Haftvermittlers 6 entfernt, siehe Figur 3d.

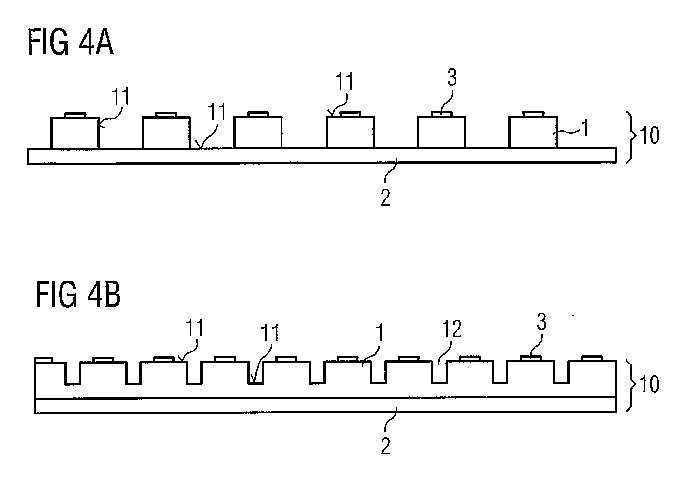

Die Lumineszenzdioden-Schichtenfolge muss nicht zwingend einstückig, beispielsweise in Form eines einstückig ausgebildeten Wafers vorliegen, sondern kann vielmehr vor dem Aufbringen des Haftvermittlers bzw. des Lumineszenzkonversionsmaterials für eine Vielzahl von Lumineszenzdiodenchips vereinzelt sein, wobei die einzelnen Teile der Lumineszenzdioden-Schichtenfolge auf einem gemeinsamen Träger 2 aufgebracht und mittels diesem in einem gemeinsamen Schichtenverbund 10 gehalten sind, siehe Figur 4a. Wird ein derart präparierter Schichtenverbund 10 zur Herstellung der mit dem Lumineszenzkonversionsmaterial versehenen Lumineszenzdiodenchips verwendet, so weisen die derart hergestellten Lumineszenzdiodenchips nicht nur auf parallel zu den Kontaktflächen 3 verlaufenden Hauptflächen, sondern auch auf Seitenflächen, die nicht parallel zu einer Haupterstreckungsebene der Kontaktflächen verlaufen, Lumineszenzkonversionsmaterial auf.

Alternativ kann die Lumineszenzdioden-Schichtenfolge 1 auch vor dem Versehen mit einem Lumineszenzkonversionsmaterial mit Gräben 12 versehen werden, so dass Haftvermittler, Leuchtstoff und/oder Lumineszenzkonversionsmaterial auch in diesen Gräben 12 aufgebracht wird bzw. werden. Die Gräben werden z.B. mittels Sägen erzeugt.

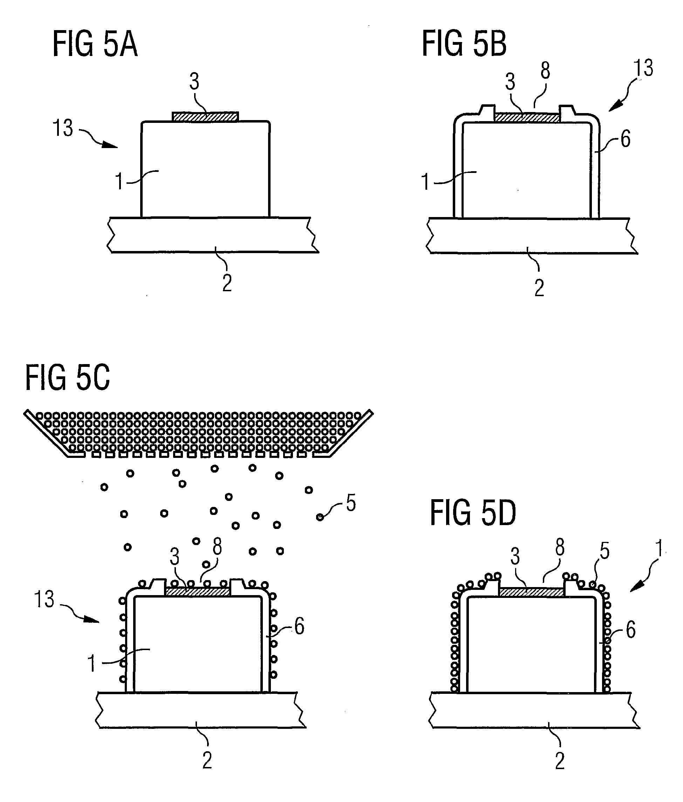

In den Figuren 5a bis 6d ist jeweils ein Ausschnitt eines Schichtenverbundes 10 dargestellt, bei dem die Lumineszenzdioden-Schichtenfolge 1 bereits für eine Vielzahl von Lumineszenzdiodenchips 13 vereinzelt ist. In Figur 5b ist ein Teil der Lumineszenzdioden-Schichtfolge 1 dargestellt, auf die eine dünne Schicht Haftvermittler 6 aufgebracht ist. Der Haftvermittler 6 ist im Bereich der elektrischen Kontaktfläche 3 selektiv entfernt, so dass die Schicht Haftvermittler 6 eine Ausnehmung 8 aufweist, in der die elektrische Kontaktschicht 3 freigelegt ist.

In Figur 5c ist das Aufbringen eines Leuchtstoffs 5 mittels eines elektrostatischen Pulversprühprozesses dargestellt. Hierzu liegt der Leuchtstoff 5 z.B. als ein Pulver mit einer mittleren Korngröße von etwa 10 µm vor. Abhängig vom angewendeten Verfahren werden die Pulverteilchen negativ oder positiv aufgeladen und der Schichtenverbund 10, der den Träger 2 und die Lumineszenzdioden-Schichtenfolge 1 umfasst, geerdet, so dass die aufgeladenen Pulverteilchen elektrostatisch angezogen werden. Der Leuchtstoff 5 bleibt nur auf dem Haftvermittler 6 dauerhaft haften (siehe Figur 5b).

Alternativ wird der Leuchtstoff z.B. mittels Vernebelns mithilfe von flüchtigen Treibmitteln oder in einem Gasstrom aufgebracht, wobei als Gas z.B. ein inertes Gas oder Luft verwendet werden kann.

Für das selektive Entfernen des Haftvermittlers 6 bzw. des Lumineszenzkonversionsmaterials 9 kann grundsätzlich anstatt eines lithografischen Prozesses und der Verwendung einer Maske auch ein Materialablösungsprozess mittels Laserbestrahlung verwendet werden. Die Verwendung einer Maske ist hierfür nicht zwingend notwendig, aber möglich. Durch die lokale Wärmeeinwirkung des Laserstrahls wird das entsprechende Material selektiv entfernt. Um den Vorgang zu beschleunigen ist es möglich, den Laserstrahl durch Strahlteiler wie etwa Prismen aufzuspalten, so dass mit nur einer Laserquelle beispielsweise vier Laserstrahlen gleichzeitig zur Verfügung gestellt werden können, wodurch die Fertigung beschleunigt wird und kostengünstiger durchgeführt werden kann.

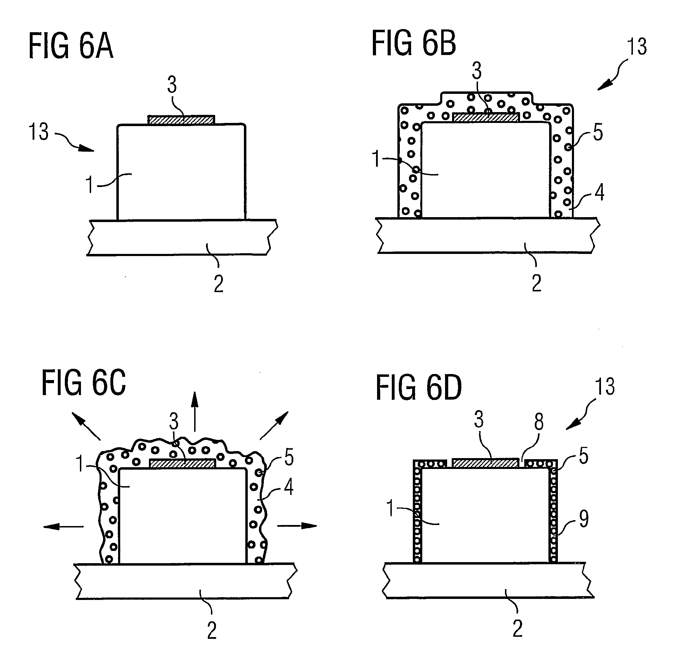

In den Figuren 6a bis 6d ist das Aufbringen eines Lumineszenzkonversionsmaterials 9 mittels einer Suspension 4 veranschaulicht. Dabei wird eine dünne Schicht einer Suspension 4 eines Leuchtstoffs 5 auf der Lumineszenzdioden-Schichtenfolge 1 aufgebracht, siehe Figur 6b. Die Suspension 4 weist z.B. Butylacetat als Lösungsmittel auf. Als Haftvermittler kann beispielsweise ein Copolyacrylat wie z.B. PERENOL F45 (Henkel KGaA) verwendet werden. Der Leuchtstoff 5 ist in dieser Suspension in einer Konzentration mit einem Volumenanteil über 40 % enthalten. Die Suspensionsschicht 4 kann durch Aufsprühen oder Auftropfen hergestellt werden.

Weiterhin können der Suspension 4 zur Erzielung einer möglichst homogenen Schicht Rheologieadditive und Netzmittel zugesetzt werden.

Ein Verlaufmittel mit entlüftenden Eigenschaften kann verwendet werden, um die Oberflächenspannnung des Haftvermittlers zu verändern und somit die Adhäsion zu verbessern. Bevorzugt wird hierfür ein Verlaufmittel verwendet, das frei von Silikon ist.

Nach dem Aufbringen wird der Schichtenverbund mit dem Träger 2 und der Lumineszenzdioden-Schichtenfolge 1 getrocknet, wobei das Lösungsmittel, wie in Figur 1c dargestellt, verdampft. Es bleibt im wesentlichen lediglich der Leuchtstoff 5 mit dem Haftvermittler auf dem Halbleiterkörper, wie in Figur 1d dargestellt, wobei das so aufgebrachte Lumineszenzkonversionsmaterial 9 von der elektrischen Kontaktfläche 3 und um die Kontaktfläche 3 herum selektiv entfernt ist, d.h. die Schicht Lumineszenzkonversionsmaterial 9 ist mit einer Ausnehmung 8 versehen, derart, dass die elektrische Kontaktfläche 3 freigelegt ist. Nachfolgend kann der Lumineszenzdiodenchip 13 aus dem Schichtenverbund 10 vereinzelt werden, indem entweder der Träger 2 von der Lumineszenzdioden-Schichtenfolge 1 entfernt wird oder zwischen den Teilen der Lumineszenzdioden-Schichtenfolge durchtrennt wird.

Bei den Verfahren können mehrere verschiedene Leuchtstoffe aufgebracht werden, was z.B. nacheinander in verschiedenen Schichten erfolgen kann. Ebenso können mehrere Schichten unterschiedlicher Lumineszenzkonversionsmateriale übereinander aufgebracht werden. Eine weitere Möglichkeit ist, weitere Schichten Haftvermittler über aufgebrachtem Leuchtstoff aufzubringen, auf denen jeweils mindestens ein weiterer Leuchtstoff aufgebracht wird.

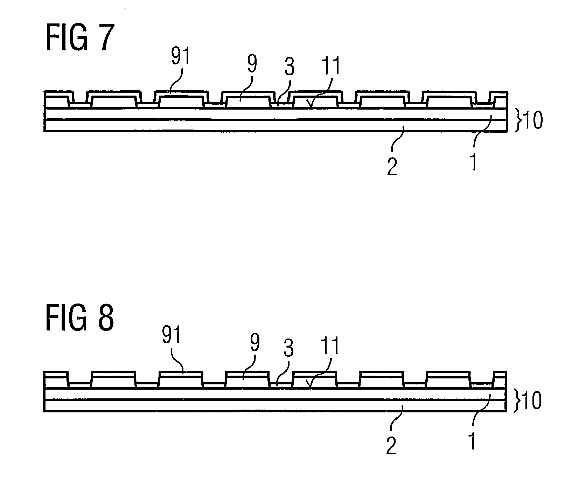

Zudem ist es auch möglich, mindestens eine Schutzschicht 91 über dem Lumineszenzkonversionsmaterial aufzubringen, mittels dem das Lumineszenzkonversionsmaterial bereits auf dem Chip teilweise oder vollständig vor Feuchtigkeit geschützt werden kann, siehe Figuren 7 und 8. Ein teilweiser Schutz kann durch Bedecken von Teilflächen des Lumineszenzkonversionsmaterials mit einer Schutzschicht 91 erreicht werden, wie in Figur 8 beispielhaft dargestellt ist. Ein vollständiger Schutz vor Feuchtigkeit kann entsprechend durch vollständiges Einkapseln des Lumineszenzkonversionsmaterials mit einer Schutzschicht 91 erreicht werden, was besonders bevorzugt ist. Ein Beispiel hierfür ist in Figur 7 dargestellt.

Zweckmäßigerweise weist die Schutzschicht 91 ein wasserdichtes Material auf. Ein geeignetes Material hierfür ist z.B. Siliziumdioxid, aus dem die Schutzschicht z.B. vollständig bestehen kann.

Die Schutzschicht 91 wird z.B. ganzflächig aufgebracht und nachfolgend z.B. mittels Lithographie partiell entfernt werden, um bedeckte elektrische Kontaktflächen freizulegen. Die Verwendung alternativer Verfahren zum Aufbringen und/oder Entfernen der Schutzschicht 91 sind selbstverständlich möglich, insbesondere alle Verfahren, die vorhergehend zum Aufbringen und/oder partiellen Entfernen des Lumineszenzkonversionsmaterials beschrieben sind, sind grundsätzlich analog anwendbar.

Durch das Aufbringen einer Schutzschicht 91 kann auch mit solchen Leuchtstoffen eine hohe Lebensdauer erreicht werden, die bei Einwirkung von Feuchtigkeit instabil oder alterungsanfällig sind. Dies spielt insbesondere bei einem direkten Aufbringen von Lumineszenzkonversionsmaterial auf Lumineszenzdiodenchips eine Rolle, bei dem kein oder deutlich weniger Matrixmaterial verwendet wird als beispielsweise bei einem Vergießen von Lumineszenzdiodenchips mit einer mit Leuchtstoffen versetzten Vergussmasse.

Es ist beispielsweise auch möglich, von vornherein zu verhindern, dass die elektrischen Kontaktflächen 3 mit Haftvermittler bzw. mit Lumineszenzkonversionsmaterial bedeckt werden. Dies kann beispielsweise unter Verwendung einer geeigneten Schablone wie beispielsweise einer Nadelkarte erfolgen, die gegen die Hauptfläche des Schichtenverbundes gepresst wird und somit mit ihren Nadeln die elektrischen Kontaktflächen zumindest teilweise abdichten.

## Patentansprüche

1. Verfahren zum Herstellen von Lumineszenzdiodenchips, die mit einem Lumineszenzkonversionsmaterial (9) versehen sind, das mindestens einen Leuchtstoff (5) aufweist, mit den Schritten:
- Bereitstellen eines Schichtenverbundes (10), der eine Lumineszenzdioden-Schichtfolge (1) für eine Vielzahl von Lumineszenzdiodenchips umfasst, die auf einer Hauptfläche für jeden Lumineszenzdiodenchip mindestens eine elektrische Kontaktfläche (3) zum elektrischen Anschließen der Lumineszenzdiodenchips aufweist;
- Aufbringen des Lumineszenzkonversionsmaterials (9) auf die Hauptfläche des Schichtenverbundes (10) ; und
- selektives Entfernen des Lumineszenzkonversionsmaterials (9) von zumindest Teilen der Kontaktflächen (3), wobei das Lumineszenzkonversionsmaterial mittels eines Pulverlackierprozesses aufgebracht wird, **dadurch gekennzeichnet, dass** das Lumineszenzkonversionsmaterial (9) zunächst mittels eines elektrostatischen Pulversprühprozesses aufgebracht wird und zum Erzielen einer Haftung an die Hauptfläche erhitzt wird.

2. Verfahren nach Anspruch 1, bei dem die Lumineszenzdiodenschichtfolge (1) eine auf einem Träger (2) aufgebrachte epitaktisch gewachsene Halbleiterschichtenfolge aufweist.

3. Verfahren nach einem der vorhergehenden Ansprüche, bei dem das Lumineszenzkonversionsmaterial mittels eines lithographischen Prozesses entfernt wird.

4. Verfahren nach Anspruch 3,
bei dem das Lumineszenzkonversionsmaterial (9) mittels eines photolithographischen Prozesses entfernt wird.

5. Verfahren nach Anspruch 3,
bei dem der lithographische Prozess die Verwendung einer vorgefertigten Maske umfasst.

6. Verfahren nach einem der Ansprüche 1 oder 2,
bei dem das Lumineszenzkonversionsmaterial unter Verwendung von Laserstrahlung entfernt wird.

## Claims

1. Method for producing luminescence diode chips provided with a luminescence conversion material (9) comprising at least one phosphor (5), comprising the following steps:
- providing a layer composite (10) comprising a luminescence diode layer sequence (1) for a multiplicity of luminescence diode chips which has on a main surface for each luminescence diode chip at least one electrical contact area (3) for electrically connecting the luminescence diode chips;
- applying the luminescence conversion material (9) to the main surface of the layer composite (10); and
- selectively removing the luminescence conversion material (9) from at least portions of the contact areas (3), wherein the luminescence conversion material is applied by means of a powder coating process,
**characterized in that**
the luminescence conversion material (9) firstly is applied by means of an electrostatic powder spraying process and is heated in order to obtain adhesion to the main surface.

2. Method according to Claim 1,
wherein the luminescence diode layer sequence (1) has an epitaxially grown semiconductor layer sequence applied on a carrier (2).

3. Method according to either of the preceding claims,
wherein the luminescence conversion material is removed by means of a lithographic process.

4. Method according to Claim 3,
wherein the luminescence conversion material (9) is removed by means of a photolithographic process.

5. Method according to Claim 3,
wherein the lithographic process comprises the use of a prefabricated mask.

6. Method according to either of Claims 1 and 2,
wherein the luminescence conversion material is removed using laser radiation.

## Revendications

1. Procédé pour la production de puces à diode électroluminescente, qui sont munies d'un matériau de conversion de luminescence (9) qui comporte au moins une substance luminescente (5), comportant les étapes :
- disposition d'un composite de couches (10) qui comprend une succession de couches de diodes électroluminescentes (1) pour une multiplicité de puces à diode électroluminescente, qui comporte sur une surface principale pour chaque puce à diode électroluminescente au moins une surface de contact électrique (3) pour la connexion électrique de la puce à diode électroluminescente ;
- application du matériau de conversion de luminescence (9) sur la surface principale du composite de couches (10) ; et
- élimination sélective du matériau de conversion de luminescence (9) au moins de parties des surfaces de surface de contact (3),
le matériau de conversion de luminescence étant appliqué au moyen d'un processus de laquage par poudre, **caractérisé en ce que** le matériau de conversion de luminescence (9) est d'abord appliqué au moyen d'un processus de projection électrostatique de poudre et est ensuite chauffé pour l'obtention d'une adhérence à la surface principale.

2. Procédé selon la revendication 1,
dans lequel la succession de couches de diodes électroluminescentes (1) comporte une succession de couches de semi-conducteurs développée par croissance épitactique, appliquée sur un support (2).

3. Procédé selon l'une quelconque des revendications précédentes,
dans lequel le matériau de conversion de luminescence est éliminé au moyen d'un processus lithographique.

4. Procédé selon la revendication 3,
dans lequel le matériau de conversion de luminescence (9) est éliminé au moyen d'un processus photolithographique.

5. Procédé selon la revendication 3,
dans lequel le processus lithographique comprend l'utilisation d'un masque préfabriqué.

6. Procédé selon l'une quelconque des revendications 1 et 2,
dans lequel on élimine le matériau de conversion de luminescence en utilisant un rayonnement laser.
